# EUROPEAN PATENT APPLICATION

(11) **EP 3 780 395 A1**
(43) Date of publication of application: **17.02.2021**
(21) Application number: 18915855.3
(22) Date of filing: 28.04.2018
(51) Int. Cl.: H03L 7/08

(54) **PHASE LOCKED LOOP**

(71) Applicant: HUAWEI TECHNOLOGIES CO., LTD., Shenzhen, Guangdong 518129 (CN)
(72) Inventor: XIE, Lei, Shenzhen, Guangdong 518129 (CN); HUANG, Jiale, Shenzhen, Guangdong 518129 (CN); LU, Lei, Shenzhen, Guangdong 518129 (CN)
(74) Representative: Gill Jennings & Every LLP
(86) International application number: PCT/CN2018/085208
(87) International publication number: WO 2019/205177

(57) **Abstract**

A phase-locked loop is disclosed, including: an oscillator; a digital switched capacitor array, where the digital switched capacitor array is connected in parallel to varactors in the oscillator, and includes N switched capacitors that are connected in parallel, where N is a positive integer greater than 1; a controller, configured to generate a level signal and a first control word based on a change in a control voltage of the oscillator; and an adjustment circuit, including: a smoothing circuit and N multiplexer switches MUXs, where the smoothing circuit is configured to slow down a flipping speed of the level signal, and obtain a smooth signal; and the N MUXs one-to-one correspond to the N switched capacitors, and the N MUXs are configured to: be selected and controlled for the smooth signal based on the first control word, and output control signals used to control the N switched capacitors to be opened or closed.

## Description

### TECHNICAL FIELD

This application relates to the field of circuit technologies, and in particular, to a phase-locked loop.

### BACKGROUND

A phase-locked loop (Phase Locked Loop) is an important circuit in a communications system. The phase-locked loop is used to maintain frequency and phase synchronization between a signal output by the phase-locked loop and a reference signal received by the phase-locked loop. When a frequency or a phase of the reference signal changes, the phase-locked loop adjusts a frequency or a phase of an output signal through a feedback system inside the phase-locked loop, until the frequency or the phase of the output signal is re-synchronized with the frequency or the phase of the reference signal.

In the phase-locked loop, an oscillator is a core unit, and a function and performance of the oscillator directly affect a function and performance of the phase-locked loop. An oscillation frequency of the oscillator varies with a temperature. Generally, when the temperature increases, the oscillation frequency of the oscillator decreases. If the temperature greatly changes, the oscillation frequency of the oscillator may also greatly change. Consequently, the phase-locked loop is out of lock. When the phase-locked loop is out of lock, a frequency and a phase of an input signal are to be locked again. As a result, performance of the phase-locked loop deteriorates. In some application scenarios, for example, a network communications system has a strict requirement on performance of the phase-locked loop, and in a process in which an external temperature changes, the phase-locked loop is not allowed to be out of lock. To improve reliability of the phase-locked loop, temperature compensation needs to be performed to resolve the foregoing problem.

In the prior art, a temperature compensation circuit can be used to implement temperature compensation for an oscillator. However, an oscillation frequency of the oscillator is still affected by a signal jitter. Consequently, the phase-locked loop cannot continuously lock a frequency.

### SUMMARY

Embodiments of this application provide a phase-locked loop, to resolve a problem that a signal jitter affects an oscillation frequency of an oscillator, so that the phase-locked loop can continuously lock a frequency when temperature compensation is performed.

An embodiment of this application provides a phase-locked loop, where the phase-locked loop includes: an oscillator; a digital switched capacitor array, where the digital switched capacitor array is connected in parallel to varactors in the oscillator, and includes N switched capacitors that are connected in parallel, where N is a positive integer greater than 1; a controller, configured to generate a level signal and a first control word based on a change in a control voltage of the oscillator; and an adjustment circuit, including: a smoothing circuit and N multiplexer switches MUXs, where the smoothing circuit is configured to slow down a flipping speed of the level signal, and obtain a smooth signal; and the N MUXs one-to-one correspond to the N switched capacitors, and the N MUXs are configured to: be selected and controlled for the smooth signal based on the first control word, and output control signals used to control the N switched capacitors to be opened or closed.

In the foregoing solution, the level signal can be used to control one switched capacitor in the digital switched capacitor array to be opened or closed. In a process in which the level signal jumps from 0 to 1 or from 1 to 0, if no processing is performed on the level signal, a capacitance value of an effective capacitor of the digital switched capacitor array instantaneously changes, and an oscillation frequency of the oscillator may jump. After the smoothing circuit slows down the flipping speed of the level signal, the digital switched capacitor array may be controlled to generate a capacitance value that continuously changes, so that the oscillation frequency of the oscillator is continuously adjustable. This can reduce a probability that the oscillation frequency of the oscillator jumps, and improve operating stability of the oscillator.

In a possible implementation, the controller is configured to update, based on the change in the control voltage of the oscillator, a second control word that is in a previous state and that is used to select and control the N MUXs, to obtain the first control word in a current state.

In a possible implementation, the first control word is encoded in a thermometer coding manner.

When the thermometer coding manner is used for encoding, each time the first control word is to be updated, an updated first control word can be obtained only by adding 1 to the first control word or subtracting 1 from the first control word. This reduces decoding logic.

In a possible implementation, the controller is configured to: when the control voltage of the oscillator is greater than a first preset voltage, add M to the second control word in the previous state, to obtain the first control word, where M is an integer greater than 0; or when the control voltage of the oscillator is less than a second preset voltage, subtract M from the second control word in the previous state, to obtain the first control word.

In a possible implementation, the smoothing circuit is a low-pass filter.

In a possible implementation, a pole of the low-pass filter is located within a loop bandwidth of the phase-locked loop.

In the foregoing solution, when the pole of the low-pass filter is located within the loop bandwidth of the phase-locked loop, stability of the loop can be improved.

In a possible implementation, a time length required by the low-pass filter to flip the level signal from 0 to 1 or from 1 to 0 is determined based on a time constant of the low-pass filter.

In a possible implementation, the adjustment circuit further includes a switch that is connected in series between an input end of the smoothing circuit and the controller; and the controller is further configured to: after determining that the control voltage of the oscillator changes, and before generating the level signal, generate a first digital signal, and control, based on the first digital signal, the switch to be closed.

In a possible implementation, the controller is further configured to: after a preset time after the level digital signal is generated and output, update the first digital signal, and control, based on the updated first digital signal, the switch to be opened.

In a possible implementation, the preset time is determined based on the time constant of the low-pass filter.

In a possible implementation, the adjustment circuit further includes an initial-point preset circuit that is connected in series between an output end of the smoothing circuit and the controller; the controller is further configured to generate a second digital signal based on the change in the control voltage of the oscillator; and the initial-point preset circuit is configured to set, based on the second digital signal, a logic level at the output end of the smoothing circuit to be opposite to a logic level of the level signal.

The foregoing solution can initialize the smoothing circuit, and can improve stability of the smoothing circuit.

In a possible implementation, the first control word includes N groups of control bits, and each group of control bits is used to control one of the N MUXs.

In a possible implementation, each group of control bits in the first control word includes two bits, and each of the N MUXs is a 4-to-1 MUX.

In a possible implementation, when each group of control bits is 00, the group of control bits controls a corresponding MUX to output a low-level signal; when each group of control bits is 11, the group of control bits controls a corresponding MUX to output a high-level signal; and when each group of control bits is 01, the group of control bits controls a corresponding MUX to output the smooth signal.

In a possible implementation, when the control voltage of the oscillator is greater than the first preset voltage, the level signal is a signal from 0 to 1; or when the control voltage of the oscillator is less than the second preset voltage, the level signal is a signal from 1 to 0.

In a possible implementation, the phase-locked loop further includes a temperature detector, where the temperature detector is configured to obtain a temperature value of the oscillator; and the controller is further configured to use, based on the temperature value, a control word corresponding to the temperature value in a preset correspondence as a control word in an initial state, where the preset correspondence is a correspondence between a temperature value and a control word.

In the foregoing solution, when temperature compensation is performed, a control word can be initialized, so that a frequency of the oscillator can be adjusted subsequently. This improves operating efficiency of a circuit.

In a possible implementation, the phase-locked loop further includes a control voltage detector, where the control voltage detector is configured to detect the control voltage based on the first preset voltage and the second preset voltage, and indicate, to the controller based on a detection result, whether the control voltage changes, where the first preset voltage is greater than the second preset voltage.

In a possible implementation, the control voltage detector is configured to: when detecting that the control voltage is greater than the first preset voltage, output a first status codeword to indicate, to the controller, that the control voltage is greater than the first preset voltage; or when detecting that the control voltage is less than the second preset voltage, output a second status codeword to indicate, to the controller, that the control voltage is less than the second preset voltage.

In a possible implementation, the control voltage detector includes a first hysteresis comparator and a second hysteresis comparator; the first preset voltage is input to a first input end of the first hysteresis comparator, and the control voltage is input to a second input end of the first hysteresis comparator; and the second preset voltage is input to a first input end of the second hysteresis comparator, and the control voltage is input to a second input end of the second hysteresis comparator.

In a possible implementation, the controller is a finite-state machine FSM.

An embodiment of this application provides a communications device, where the communications device includes any one of the foregoing phase-locked loops.

An embodiment of this application provides a temperature compensation circuit, where the temperature compensation circuit includes: a digital switched capacitor array, where the digital switched capacitor array is connected in parallel to varactors in an oscillator, and includes N switched capacitors that are connected in parallel, where N is a positive integer greater than 1; a controller, configured to generate a level signal and a first control word based on a change in a control voltage of the oscillator; and an adjustment circuit, including: a smoothing circuit and N multiplexer switches MUXs, where the smoothing circuit is configured to slow down a flipping speed of the level signal, and obtain a smooth signal; and the N MUXs one-to-one correspond to the N switched capacitors, and the N MUXs are configured to: be selected and controlled for the smooth signal based on the first control word, and output control signals used to control the N switched capacitors to be opened or closed.

In the foregoing solution, the level signal can be used to control one switched capacitor in the digital switched capacitor array to be opened or closed. In a process in which the level signal jumps from 0 to 1 or from 1 to 0, after the smoothing circuit slows down the flipping speed of the level signal, the digital switched capacitor array may be controlled to generate a capacitance value that continuously changes, so that an oscillation frequency of the oscillator is continuously adjustable. This can reduce a probability that the oscillation frequency of the oscillator jumps, and improve operating stability of the oscillator.

### BRIEF DESCRIPTION OF DRAWINGS

FIG. 1 is a schematic structural diagram of a phase-locked loop according to an embodiment of this application;
FIG. 2 is a schematic structural diagram of an adjustment circuit according to an embodiment of this application;
FIG. 3 is a schematic diagram of signal processing on a signal smoothing circuit according to an embodiment of this application;
FIG. 4 is a schematic diagram of outputting a signal by a controller according to an embodiment of this application;
FIG. 5 is a schematic diagram of outputting a signal by a controller according to an embodiment of this application; and
FIG. 6 is a schematic structural diagram of a control voltage detector according to an embodiment of this application.

### DESCRIPTION OF EMBODIMENTS

The embodiments of this application may be applied to various types of phase-locked loops such as a charge-pump phase-locked loop (Charge Pump Phase Locked Loop, CPPLL) and an all digital phase-locked loop (All Digital Phase Locked Loop, ADPLL).

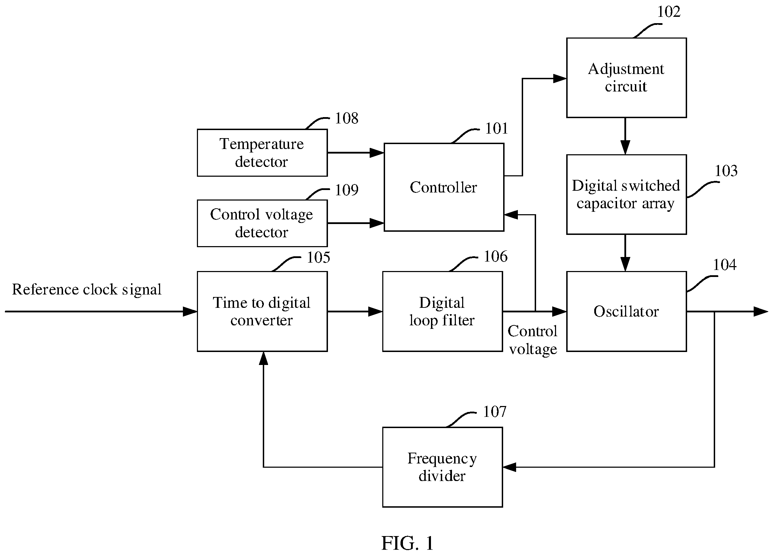

FIG. 1 is a schematic structural diagram of a phase-locked loop according to an embodiment of this application.

An all digital phase-locked loop is used as an example for description in FIG. 1. For another type of phase-locked loop, refer to the description in FIG. 1. Details are not described herein.

The phase-locked loop shown in FIG. 1 includes: a controller 101, an adjustment circuit 102, a digital switched capacitor array 103, an oscillator 104, a time to digital converter (Time to Digital Convert, TDC) 105, a digital loop filter (Digital Loop Filter, DLF) 106, a frequency divider (divider, DIV) 107, and the like. Optionally, the phase-locked loop further includes a temperature detector 108 and a control voltage detector 109. The temperature detector 108 is configured to obtain a temperature value of the oscillator. The control voltage detector 109 is configured to detect a control voltage of the oscillator 104.

In this embodiment of this application, the time to digital converter 105 is configured to generate a phase difference signal based on a phase relationship between a received reference clock signal and a negative feedback clock signal output by the frequency divider 107, where the phase difference signal indicates a phase difference between the frequency multiplied signal and the negative feedback clock signal.

The digital loop filter 106 is configured to perform loop filtering on the phase difference signal to obtain the control voltage of the oscillator 104.

The oscillator 104 is configured to output an oscillation signal under control of the control voltage.

The frequency divider 107 is configured to perform frequency division on the oscillation signal to obtain the negative feedback clock signal.

The controller 101 is configured to generate a level signal and a first control word based on a change in the control voltage of the oscillator 104.

Specifically, the controller 101 is configured to update, based on the change in the control voltage of the oscillator, a second control word that is in a previous state and that is used to select and control the N MUXs, to obtain the first control word in a current state.

It should be noted that, after the phase-locked loop is stable, the change in the control voltage of the oscillator is caused by a temperature. An oscillation frequency of the oscillator varies with the temperature. Generally, when the temperature increases, the oscillation frequency of the oscillator decreases, and the control voltage of the oscillator increases. Correspondingly, when the temperature decreases, the oscillation frequency of the oscillator increases, and the control voltage of the oscillator decreases. In this case, temperature compensation needs to be performed on the phase-locked loop.

Optionally, in this embodiment of this application, the first control word is encoded in a thermometer coding manner. When the thermometer coding manner is used for encoding, each time the first control word is to be updated, an updated first control word can be obtained only by adding 1 to the first control word or subtracting 1 from the first control word. This reduces decoding logic.

In this embodiment of this application, the controller 101 may be a finite-state machine (finite-state machine, FSM).

The adjustment circuit 102 may include a smoothing circuit, and N multiplexer switches (MUX).

The smoothing circuit is configured to slow down a flipping speed of the level signal, and obtain a smooth signal.

The N MUXs one-to-one correspond to the N switched capacitors, and the N MUXs are configured to: be selected and controlled for the smooth signal based on the first control word, and output control signals used to control the N switched capacitors to be opened or closed.

The digital switched capacitor array 103 includes the N switched capacitors connected in parallel (which may also be referred to as a digital switched capacitor bank). The digital switched capacitor array 103 is connected in parallel to varactors in the oscillator 104 in the phase-locked loop, where N is an integer greater than 0. A value of N may be determined based on an actual case. This is not limited in the embodiments of this application.

In this embodiment of this application, each switched capacitor in the digital switched capacitor array 103 may be implemented through an N-type metal-oxide-semiconductor (Metal Oxide Semiconductor, MOS) transistor or a P-type MOS transistor. In this embodiment of this application, a control end of each switched capacitor in the digital switched capacitor array 103 is connected to an output end of one MUX in the adjustment circuit 102; and an output end of the multiplexer switch may output a control signal used to control and adjust the switched capacitor to be closed or opened, to adjust a capacitance value of an effective capacitor of the switched capacitor.

Specifically, when each switched capacitor is the N-type metal-oxide-semiconductor (Metal Oxide Semiconductor, MOS) transistor, and an output end of a multiplexer switch outputs a high-level signal, a capacitance value of an effective capacitor of a switched capacitor connected to the output end of the multiplexer switch is adjusted to a minimum value; or when an output end of a multiplexer switch outputs a low-level signal, a capacitance value of an effective capacitor of a switched capacitor connected to the output end of the multiplexer switch is adjusted to a maximum value. In this scenario, when the temperature increases, and the control voltage of the oscillator 104 is greater than a first preset voltage, the controller 101 generates the level signal at a high level. Correspondingly, when the temperature decreases, and the control voltage of the oscillator 104 is less than a second preset voltage, the controller 101 generates the level signal at a low level.

When each switched capacitor is the P-type MOS transistor, and an output end of a multiplexer switch outputs a low-level signal, a capacitance value of an effective capacitor of a switched capacitor connected to the output end of the multiplexer switch is adjusted to a minimum value; or when an output end of a multiplexer switch outputs a high-level signal, a capacitance value of an effective capacitor of a switched capacitor connected to the output end of the multiplexer switch is adjusted to a maximum value. In this scenario, when the temperature increases, and the control voltage of the oscillator 104 is greater than a first preset voltage, the controller 101 generates the level signal with a low level. Correspondingly, when the temperature decreases, and the control voltage of the oscillator 104 is less than a second preset voltage, the controller 101 generates the level signal with a high level.

A capacitance value of the digital switched capacitor array 103 is changed under control of the first control word and the smooth signal, to change the oscillation frequency of the oscillator 104, and adjust the control voltage. Specifically, the oscillation frequency of the oscillator 104 is related to a capacitance value of an effective capacitor in the oscillator 104. In this embodiment of this application, a capacitance value of an effective capacitor in the digital switched capacitor array 103 is adjusted, to adjust the capacitance value of the capacitor in the oscillator 104, and change the oscillation frequency of the oscillator 104. When the oscillation frequency of the oscillator 104 decreases due to an increase in the temperature, a capacitance value of an effective capacitor of at least one switched capacitor in the digital switched capacitor array 103 may be decreased, to decrease the capacitance value of the effective capacitor in the oscillator 104, increase the oscillation frequency of the oscillator 104, and decrease the control voltage. Correspondingly, when the oscillation frequency of the oscillator 104 increases due to a decrease in the temperature, a capacitance value of an effective capacitor of at least one switched capacitor in the digital switched capacitor array 103 may be increased, to increase the capacitance value of the effective capacitor in the oscillator 104, decrease the oscillation frequency of the oscillator 104, and increase the control voltage.

In this embodiment of this application, the digital switched capacitor array has the following advantages: 1. The digital switched capacitor array has a relatively high quality (Q) factor, and does not deteriorate a phase noise of the oscillator. 2. A control signal of the digital switched capacitor array is a digital signal (a power supply and ground), and has a low signal noise. 3. The digital switched capacitor array has a relatively wide capacitance tuning range, occupies a relatively small area, and can implement a higher temperature compensation capability in such a smaller area.

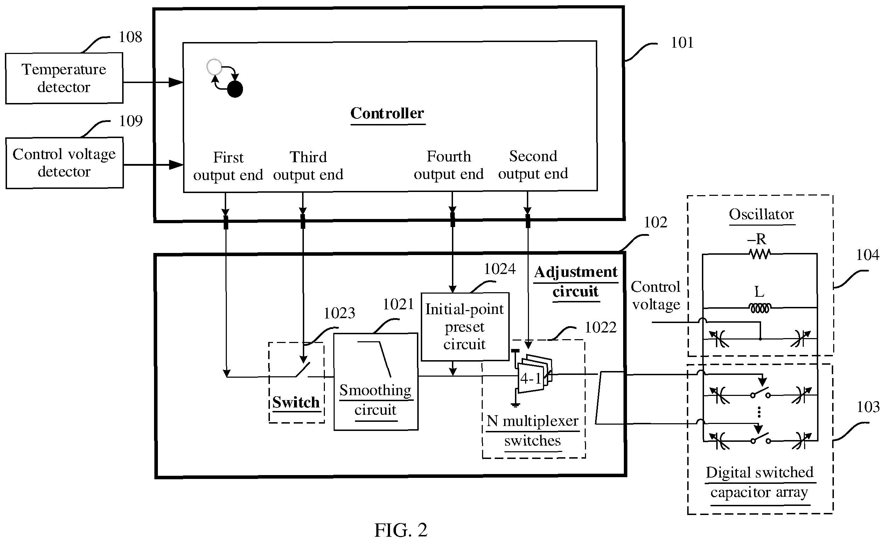

The following describes the foregoing process in detail with reference to a specific structure of the adjustment circuit. FIG. 2 is a schematic structural diagram of an adjustment circuit according to an embodiment of this application.

The adjustment circuit 102 shown in FIG. 2 includes a smoothing circuit 1021 and N multiplexer switches 1022. Further, the adjustment circuit 102 further includes a switch 1023 and an initial-point preset circuit 1024.

The N MUXs 1022 one-to-one correspond to the N switched capacitors, and the N MUXs 1022 are configured to be selected for the smooth signal under control of the first control word. Output signals of the N MUXs 1022 may be referred to as switch control signals, and are used to control capacitance values of the N switched capacitors. Specifically, an output end of each of the N MUXs 1022 is connected to a control end of one corresponding switched capacitor in the N switched capacitors.

In this embodiment of this application, each of the N MUXs 1022 is at least a 4-to-1 MUX. One input end of each of the N MUXs 1022 receives a high-level signal, one input end is grounded, one input end is connected to an output end of the smoothing circuit 1021, and another input end is left unconnected.

An input end of the smoothing circuit 1021 is connected to a first output end of the controller, and an output end of the smoothing circuit 1021 is connected to an input end of each of the N multiplexer switches. The smoothing circuit 1021 is configured to slow down the flipping speed of the level signal, and obtain the smooth signal.

In the foregoing solution, because the level signal is used to control a capacitance value of an effective capacitor of the digital switched capacitor array 103, in a process in which the level signal jumps from 0 to 1 or from 1 to 0, the oscillation frequency of the oscillator may jump. After the smoothing circuit 1021 slows down the flipping speed of the level signal, a capacitance value that continuously changes is generated, so that the oscillation frequency of the oscillator is continuously adjustable. This can reduce a probability that the oscillation frequency of the oscillator jumps, and improve operating stability of the oscillator.

Optionally, in this embodiment of this application, the smoothing circuit 1021 may be a low-pass filter.

It should be noted that in this embodiment of this application, the smoothing circuit may be specifically implemented in a plurality of manners. This is not limited in this embodiment of this application, and other smoothing circuits that can slow down a flipping speed of a signal are not described one by one through examples.

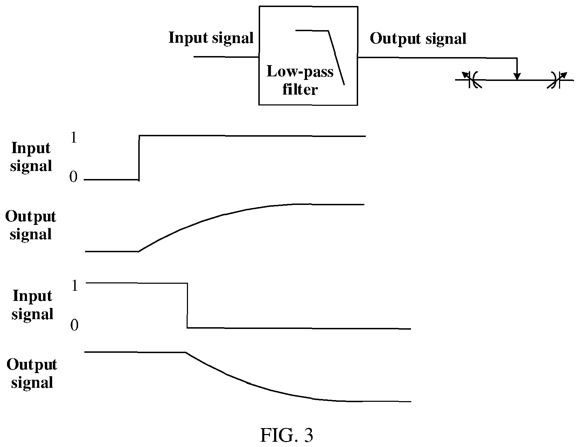

A process of smoothing a signal by the low-pass filter may be shown in FIG. 3. In FIG. 3, when an input signal received by the low-pass filter jumps from 0 (a low level) to 1 (a high level), the low-pass filter may slow down a flipping speed of the input signal, and output an output signal that is smoothly flipped. Correspondingly, when an input signal received by the low-pass filter jumps from 1 (a high level) to 0 (a low level), the low-pass filter may slow down a flipping speed of the input signal, and output an output signal that is smoothly flipped. The low-pass filter outputs an output signal that slowly changes, to control a capacitance value of a digital switched capacitor connected to the oscillator to slowly change, and to generate a capacitance value that continuously changes. This prevents the oscillation frequency from jumping due to a dramatic change in the capacitance value of the oscillator. In this way, the oscillation frequency is continuously adjustable.

A time length required by the low-pass filter to flip the level signal from 0 to 1 or from 1 to 0 may be a time constant of the low-pass filter. The time constant t of the low-pass filter is equal to RC (t = RC), where R represents a resistance value of the low-pass filter, and C represents a capacitance value of the low-pass filter.

Further, a pole of the low-pass filter is located within a loop bandwidth of the phase-locked loop. When the pole of the low-pass filter is located within the loop bandwidth of the phase-locked loop, stability of the phase-locked loop can be improved.

In this embodiment of this application, the switch 1023 in the adjustment circuit 102 is connected in series between the input end of the smoothing circuit 1021 and the controller 101. The initial-point preset circuit 1024 in the adjustment circuit 102 is connected in series between the output end of the smoothing circuit 1021 and the controller 101. For details, refer to FIG. 3. When the smoothing circuit 1021 is the low-pass filter, the low-pass filter needs to be initialized before performing filtering. To be specific, a level at an output end of the low-pass filter is set to be different from a level of a signal that is input from an input end of the low-pass filter. In this way, the controller 101 may control, based on a second digital signal, the initial-point preset circuit 1024 to output a signal whose logic level is opposite to a logic level of the level signal, to initialize the low-pass filter.

With reference to FIG. 3, the controller 101 includes at least four output ends: a first output end to a fourth output end. The first output end is configured to output the level signal, and is connected to an input end of the switch 1023 in the adjustment circuit 102. A second output end is configured to output the first control word, and is connected to control ends of the N MUXs 1022 in the adjustment circuit 102. A third output end is configured to output a first digital signal or a fourth digital signal, and is connected to a control end of the switch 1023 in the adjustment circuit 102. The fourth output end is configured to output the second digital signal, and is connected to an input end of the initial-point preset circuit 1024 in the adjustment circuit 102.

In this embodiment of this application, the controller 101 may store a preset correspondence, where the preset correspondence is a correspondence between a temperature value and a control word. When the phase-locked loop is initialized, the controller 101 obtains a temperature value of the oscillator through the temperature detector 108, and then uses, based on the temperature value, a control word corresponding to the temperature value in the preset correspondence as a control word in an initial state.

For example, a correspondence between a temperature and a control word may be shown in Table 1.

**Table 1**

| Temperature value (°C) | Control word |
|---|---|
| 0 to 10 | 00 00 00 00 |
| 11 to 20 | 00 00 00 11 |
| 21 to 30 | 00 00 11 11 |
| 31 to 40 | 00 11 11 11 |

With reference to Table 1, when the temperature value obtained by the controller 101 is 15, the controller 101 determines that a control word in the initial state is 00 00 00 11.

Certainly, Table 1 shows merely an example. The correspondence between the temperature and the control word may alternatively have another form. Details are not described one by one through examples herein.

It should be noted that the first control word includes N groups of control bits, and each group of control bits is used to control one of the N MUXs. Optionally, when each switched capacitor in the digital switched capacitor array 103 is the N-type MOS transistor, each group of control bits in the first control word includes two bits. When each group of control bits is 00, the group of control bits is used to control a corresponding MUX to output a low-level signal. When each group of control bits is 11, the group of control bits is used to control a corresponding MUX to output a high-level signal. When each group of control bits is 01, the group of control bits is used to control a corresponding MUX to output the smooth signal. When each group of control bits is 01, the group of control bits is used to control a corresponding MUX to output an invalid signal.

Optionally, when each switched capacitor in the digital switched capacitor array 103 is the P-type MOS transistor, each group of control bits in the first control word includes two bits. When each group of control bits is 00, the group of control bits is used to control a corresponding MUX to output a high-level signal. When each group of control bits is 11, the group of control bits is used to control a corresponding MUX to output a low-level signal. When each group of control bits is 01, the group of control bits is used to control a corresponding MUX to output the smooth signal. When each group of control bits is 01, the group of control bits is used to control a corresponding MUX to output an invalid signal.

Certainly, in this embodiment of this application, 01 are reserved bits. In a normal case, a value of any group of control bits in the first control word generated by the controller 101 is not set to 01.

It should be noted that, in this embodiment of this application, each group of control bits in a control word in the preset correspondence is 00 or 11, to ensure that an initial value of the first control word output by the controller 101 is used to control each of the N MUXs 1022 to output a high-level signal or a low-level signal.

When the phase-locked loop is stable, the control voltage of the oscillator 104 falls within a stable range. When the temperature increases or decreases, the oscillation frequency of the oscillator may jump. This causes a change in the control voltage of the oscillator 104.

For example, each switched capacitor in the digital switched capacitor array 103 is the N-type MOS transistor. It is assumed that when the phase-locked loop is stable, the control voltage of the oscillator 104 falls within a range [VL, VH], where VL represents the second preset voltage, and VH represents the first preset voltage. The first preset voltage is greater than the second preset voltage. The following separately describes, in different cases, the level signal to the second digital signal that are generated by the controller 101 when the control voltage of the oscillator 104 changes. It should be noted that a logic level of the level signal generated by the controller 101 when each switched capacitor in the digital switched capacitor array 103 is the P-type MOS transistor is opposite to a logic level generated by the controller 101 when each switched capacitor in the digital switched capacitor array 103 is the N-type MOS transistor. Details are not described herein.

In a first possible scenario, the temperature increases, and the control voltage of the oscillator 104 is greater than the first preset voltage.

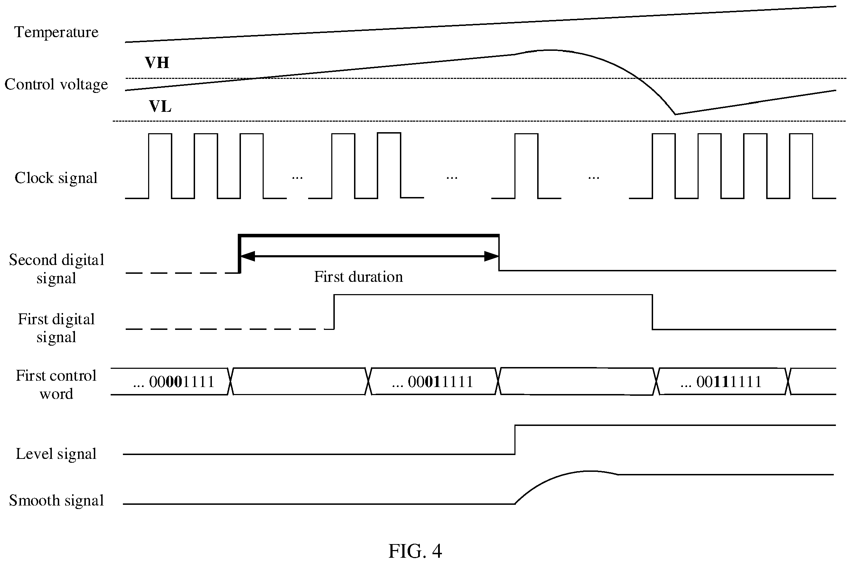

In this scenario, a signal output by the controller 101 may be shown in FIG. 4.

Step 1: The controller 101 outputs the second digital signal, where the second digital signal is used to control the initial-point preset circuit 1024 to set, based on the second digital signal, a logic level at the output end of the smoothing circuit to be opposite to the logic level of the level signal.

For example, the initial-point preset circuit 1024 is controlled to be a phase inverter. In this case, the second digital signal is a high-level signal, and the initial-point preset circuit 1024 outputs a low-level signal.

Optionally, when the second digital signal is a high-level signal, duration of a high level is first duration, and a specific value of the first duration may be determined based on an actual case. Details are not described herein.

Step 2: The controller 101 generates the first digital signal, where the first digital signal is used to control the switch 1023 to be closed.

After the switch 1023 is closed, the first output end of the controller 101 is connected to the input end of the smoothing circuit 1021.

When the control end of the switch 1023 is closed after receiving a high-level signal, in this step, the first digital signal generated by the controller 101 may be a high-level signal. Other cases are not described one by one through examples.

Step 3: The controller 101 adds M to the second control word in the previous state, to obtain the first control word, where M is an integer greater than 0.

For example, M is 1. When the first control word is encoded in the thermometer coding manner, the first control word includes N groups of bits, and each group of bits includes two bits. The controller 101 adds 1 to the currently output first control word, to obtain an updated first control word.

Table 2 is used as an example. If the currently output first control word is 00 00 11 11, the updated first control word is 00 01 11 11.

The first bit and the second bit are used to control a control end of a first multiplexer switch. The third bit and the fourth bit are used to control a control end of a second multiplexer switch. The fifth bit and the sixth bit are used to control a control end of a third multiplexer switch. The seventh bit and the eighth bit are used to control a control end of a fourth multiplexer switch. With reference to the foregoing description, based on the updated first control word, if an input end that is of the first multiplexer switch and that is grounded is selected, the multiplexer switch outputs a low level; if an input end that is of the second multiplexer switch and that is connected to the output end of the smoothing circuit 1021 is selected, the multiplexer switch outputs a smooth signal; and if input ends of the third and fourth multiplexer switches for receiving a high level are selected, the multiplexer switches output high levels.

Step 4: The controller 101 generates the level signal.

Specifically, the controller 101 outputs a signal that jumps from 0 to 1, that is, outputs the level signal at a high level.

In this case, the smoothing circuit 1021 slows down the flipping speed of the level signal, obtains the smooth signal, and outputs the smooth signal to the N MUXs.

When one MUX in the N MUXs is selected for the smooth signal based on a group of control bits corresponding to the MUX, the MUX outputs the smooth signal to a switched capacitor corresponding to the MUX.

When an output end of a multiplexer switch outputs a high-level signal, a capacitance value of an effective capacitor of a switched capacitor connected to the output end of the multiplexer switch is adjusted to a minimum value. In this case, the capacitance value of the digital switched capacitor array 103 is decreased based on the updated first control word. After the capacitance value of the digital switched capacitor array 103 is decreased, the oscillation frequency of the oscillator 104 increases, and the temperature value of the oscillator 104 decreases.

Step 5: After a preset time period after the controller 101 generates and outputs the level signal, the controller 101 updates the first digital signal, and controls, based on an updated first digital signal, the switch 1024 to be opened.

The preset time period is determined based on the time constant of the low-pass filter. For example, the preset time period is K times the time constant, and K is a value greater than 1.

When the control end of the switch 1023 is closed after receiving a low-level signal, in this step, the fourth digital signal generated by the controller 101 may be a low-level signal. Other cases are not described one by one through examples.

Step 6: The controller 101 updates the first control word to obtain an updated first control word.

Specifically, when the first control word is encoded in the thermometer coding manner, the first control word includes N groups of bits, and each group of bits includes two bits. The controller 101 adds 1 to the first control word, to obtain an updated first control word.

With reference to the foregoing description, if the first control word is 00 01 11 11, the obtained updated first control word is 00 11 11 11.

In this case, an input end of a MUX that originally outputs the smooth signal is selected based on the second control word to output a high-level signal, so that the MUX outputs the high-level signal, and a capacitance value of a switched capacitor corresponding to the MUX is adjusted to a minimum value.

When determining that the control voltage of the oscillator still increases, the controller 101 repeats the foregoing steps until the control voltage decreases.

In a second possible scenario, the temperature decreases, and the control voltage of the oscillator 104 is less than the second preset voltage.

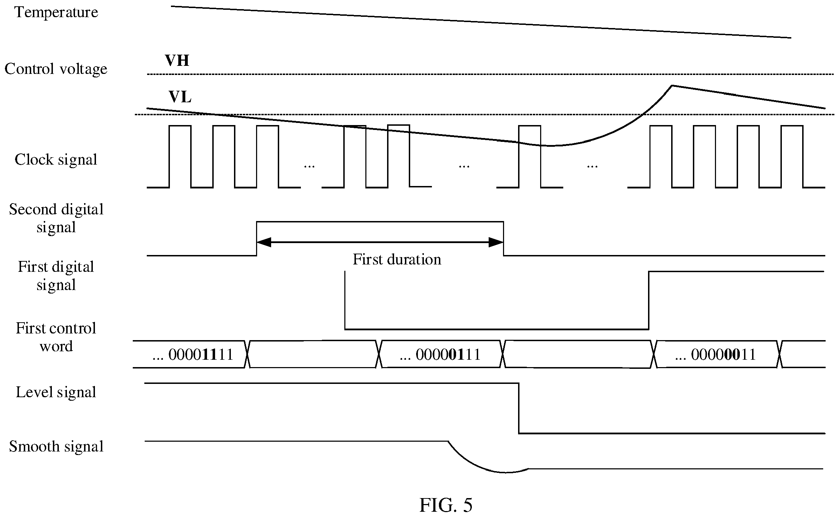

In this scenario, a signal output by the controller 101 may be shown in FIG. 5.

Step 1: The controller 101 outputs the second digital signal, where the second digital signal is used to control the initial-point preset circuit 1024 to generate and output a signal whose logic level is opposite to the logic level of the level signal.

For example, the initial-point preset circuit 1024 is controlled to be a phase inverter. In this case, the second digital signal is a low-level signal, and the initial-point preset circuit 1024 outputs a high-level signal.

Optionally, when the second digital signal is a low-level signal, duration of a low level is first duration, and a specific value of the first duration may be determined based on an actual case. Details are not described herein.

Step 2: The controller 101 generates the first digital signal, where the first digital signal is used to control the switch 1023 to be closed.

After the switch 1023 is closed, the first output end of the controller 101 is connected to the input end of the smoothing circuit 1021.

When the control end of the switch 1023 is closed after receiving a high-level signal, in this step, the first digital signal generated by the controller 101 may be a high-level signal. Other cases are not described one by one through examples.

Step 3: The controller 101 subtracts M from the second control word in the previous state, to obtain the first control word.

For example, M is 1. When the first control word is encoded in the thermometer coding manner, the first control word includes N groups of bits, and each group of bits includes two bits. The controller 101 subtracts 1 from the currently output first control word, to obtain an updated first control word.

Table 2 is used as an example. If the currently output first control word is 00 11 11 11, the updated first control word is 00 01 11 11.

Step 4: The controller 101 generates the level signal.

Specifically, the controller 101 outputs a signal that jumps from 1 to 0, that is, outputs the level signal at a low level.

In this case, the smoothing circuit 1021 slows down the flipping speed of the level signal, obtains the smooth signal, and outputs the smooth signal to the N MUXs.

When one MUX in the N MUXs is selected for the smooth signal based on a group of control bits corresponding to the MUX, the MUX outputs the smooth signal to a switched capacitor corresponding to the MUX.

When an output end of a multiplexer switch outputs a low-level signal, a capacitance value of an effective capacitor of a switched capacitor connected to the output end of the multiplexer switch is adjusted to a maximum value. In this case, the capacitance value of the digital switched capacitor array 103 is increased based on the updated first control word. After the capacitance value of the digital switched capacitor array 103 is increased, the oscillation frequency of the oscillator 104 decreases, and the temperature value of the oscillator 104 increases.

Step 5: After a preset time period after the controller 101 generates and outputs the level signal, the controller 101 updates the first digital signal, and controls, based on an updated first digital signal, the switch 1024 to be opened.

The preset time period is determined based on the time constant of the low-pass filter. For example, the preset time period is K times the time constant, and K is a value greater than 1.

Step 6: The controller 101 re-updates the first control word to obtain an updated first control word.

Specifically, when the first control word is encoded in the thermometer coding manner, the first control word includes N groups of bits, and each group of bits includes two bits. The controller 101 subtracts 1 from the updated first control word, to obtain an updated first control word.

With reference to the foregoing description, if the first control word is 00 01 11 11, the obtained updated first control word is 00 00 11 11.

In this case, an input end of a MUX that originally outputs the smooth signal is selected based on the updated first control word to output a low-level signal, so that the MUX outputs the low-level signal, and a capacitance value of a switched capacitor corresponding to the MUX is adjusted to a maximum value.

When determining that the control voltage of the oscillator still decreases, the controller 101 repeats the foregoing steps until the control voltage increases.

In a third possible scenario, when the control voltage is greater than or equal to the second preset voltage and is less than or equal to the first preset voltage, the controller 101 may output the first control word that is unchanged.

In this case, the controller 101 does not need to output the level signal to the second digital signal.

In this embodiment of this application, the controller 101 may determine, based on a detection result obtained after the control voltage detector 109 detects the control voltage, whether the control voltage changes. The following provides detailed descriptions.

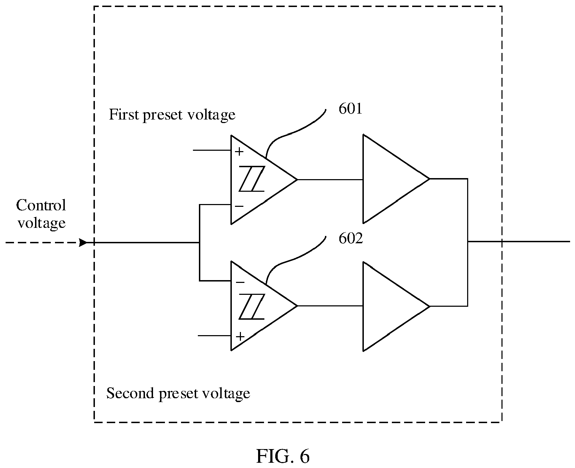

A structure of the control voltage detector 109 may be shown in FIG. 6. In FIG. 6, the control voltage detector includes a first hysteresis comparator 601 and a second hysteresis comparator 602. The first preset voltage is input to a first input end of the first hysteresis comparator 601, and the control voltage is input to a second input end of the first hysteresis comparator 601. The second preset voltage is input to a first input end of the second hysteresis comparator 602, and the control voltage is input to a second input end of the second hysteresis comparator 602. An output end of the first hysteresis comparator 601 is connected to a positive electrode of a diode, an output end of the second hysteresis comparator 602 is connected to a positive electrode of a diode, and negative electrodes of the two diodes are connected to each other and used as an output end of the control voltage detector 109.

An operating process of the control voltage detector 109 is as follows: When the control voltage is greater than the first preset voltage, the first hysteresis comparator 601 outputs a low level; or when the control voltage is less than or equal to the first preset voltage, the first hysteresis comparator 601 outputs a high level. When the control voltage is greater than or equal to the second preset voltage, the second hysteresis comparator 602 outputs a low level; or when the control voltage is less than the second preset voltage, the second hysteresis comparator 602 outputs a high level.

With reference to the foregoing descriptions, for the detection result output by the control voltage detector 106, refer to Table 2.

**Table 2**

| Control voltage | Detection result of the control voltage detector |
|---|---|
| Greater than the first preset voltage | First codeword (00) |
| Greater than or equal to the second preset voltage and less than or equal to the first preset voltage | Third codeword (10) |
| Less than the second preset voltage | Second codeword (11) |

With reference to Table 2, when the detection result output by the control voltage detector 109 is the third codeword, the controller 101 may determine that the control voltage of the oscillator does not change, in other words, falls within a preset voltage range. In this case, temperature compensation does not need to be performed on the phase-locked loop. When the detection result output by the control voltage detector 109 is the first codeword or the second codeword, the controller 101 may determine that the control voltage changes. Specifically, when detecting that the control voltage detector 109 outputs the first codeword, the controller 101 determines that the control voltage is greater than the first preset voltage. When detecting that the control voltage detector 109 outputs the second codeword, the controller 101 determines that the control voltage is less than the second preset voltage.

FIG. 6 and Table 2 show merely examples. The control voltage detector 106 may alternatively be implemented in another form. The controller 101 may alternatively determine, in another manner, whether the control voltage of the oscillator falls within the preset voltage range. Details are not described one by one through examples herein.

In this embodiment of this application, the control voltage detector 109 may alternatively be an analog-to-digital converter, and is configured to convert an obtained voltage value of the control voltage into a digital signal having a plurality of bits, where the digital signal is usually referred to as a control codeword. The controller 101 may compare the obtained control codeword with a codeword of the first preset voltage and a codeword of the second preset voltage, to determine whether the control voltage changes. For example, the control codeword obtained by the controller 101 through the control voltage detector 109 is 0110, the codeword of the first preset voltage is 0100, and the codeword of the second preset voltage is 1001. The controller 101 may determine, through comparison, that the control voltage does not change.

An embodiment of this application further provides a communications device. The communications device includes any one of the foregoing phase-locked loops.

The communications device may be a mobile phone (mobile phone), a tablet computer (Pad), a computer with a wireless transceiver function, a virtual reality (virtual reality, VR) terminal, an augmented reality (augmented reality, AR) terminal, a wireless terminal in industrial control (industrial control), a wireless terminal in self driving (self driving), a wireless terminal in telemedicine (remote medical), a wireless terminal in a smart grid (smart grid), a radio network controller (radio network controller, RNC) or a NodeB (NodeB, NB), a base station controller (base station controller, BSC), a base transceiver station (base transceiver station, BTS), a home base station, or the like.

An embodiment of this application further provides a temperature compensation circuit, including:
a digital switched capacitor array, where the digital switched capacitor array is connected in parallel to varactors in an oscillator, and includes N switched capacitors that are connected in parallel, where N is a positive integer greater than 1;
a controller, configured to generate a level signal and a first control word based on a change in a control voltage of the oscillator; and
an adjustment circuit, including: a smoothing circuit and N multiplexer switches MUXs, where
the smoothing circuit is configured to slow down a flipping speed of the level signal, and obtain a smooth signal; and
the N MUXs one-to-one correspond to the N switched capacitors, and the N MUXs are configured to: be selected and controlled for the smooth signal based on the first control word, and output control signals used to control the N switched capacitors to be opened or closed.

For other content included in the temperature compensation circuit, refer to the foregoing descriptions in the phase-locked loop embodiment. Details are not described herein again.

It is clear that a person skilled in the art can make various modifications and variations to this application without departing from the scope of this application. This application is intended to cover these modifications and variations provided that the modifications and variations fall within the scope of protection defined by the following claims.

## Claims

1. A phase-locked loop, comprising:
an oscillator;
a digital switched capacitor array, wherein the digital switched capacitor array is connected in parallel to varactors in the oscillator, and comprises N switched capacitors that are connected in parallel, wherein N is a positive integer greater than 1;
a controller, configured to generate a level signal and a first control word based on a change in a control voltage of the oscillator; and
an adjustment circuit, comprising: a smoothing circuit and N multiplexer switches MUXs, wherein
the smoothing circuit is configured to slow down a flipping speed of the level signal, and obtain a smooth signal; and
the N MUXs one-to-one correspond to the N switched capacitors, and the N MUXs are configured to: be selected and controlled for the smooth signal based on the first control word, and output control signals used to control the N switched capacitors to be opened or closed.

2. The phase-locked loop according to claim 1, wherein the controller is configured to update, based on the change in the control voltage of the oscillator, a second control word that is in a previous state and that is used to select and control the N MUXs, to obtain the first control word in a current state.

3. The phase-locked loop according to claim 2, wherein the controller is configured to:
when the control voltage of the oscillator is greater than a first preset voltage, add M to the second control word in the previous state, to obtain the first control word, wherein M is an integer greater than 0; or
when the control voltage of the oscillator is less than a second preset voltage, subtract M from the second control word in the previous state, to obtain the first control word.

4. The phase-locked loop according to any one of claims 1 to 3, wherein the smoothing circuit is a low-pass filter.

5. The phase-locked loop according to claim 4, wherein a pole of the low-pass filter is located within a loop bandwidth of the phase-locked loop.

6. The phase-locked loop according to either of claims 4 and 5, wherein a time length required by the low-pass filter to flip the level signal from 0 to 1 or from 1 to 0 is determined based on a time constant of the low-pass filter.

7. The phase-locked loop according to any one of claims 4 to 6, wherein the adjustment circuit further comprises a switch connected in series between an input end of the smoothing circuit and the controller; and
the controller is further configured to: after determining that the control voltage of the oscillator changes, and before generating the level signal, generate a first digital signal, and control, based on the first digital signal, the switch to be closed.

8. The phase-locked loop according to any one of claims 4 to 7, wherein the adjustment circuit further comprises an initial-point preset circuit that is connected in series between an output end of the smoothing circuit and the controller;
the controller is further configured to generate a second digital signal based on the change in the control voltage of the oscillator; and
the initial-point preset circuit is configured to set, based on the second digital signal, a logic level at the output end of the smoothing circuit to be opposite to a logic level of the level signal.

9. The phase-locked loop according to any one of claims 1 to 8, wherein the first control word comprises N groups of control bits, and each group of control bits is used to control one of the N MUXs.

10. The phase-locked loop according to claim 9, wherein each group of control bits in the first control word comprises two bits, and each of the N MUXs is a 4-to-1 MUX.

11. The phase-locked loop according to claim 10, wherein when each group of control bits is 00, the group of control bits controls a corresponding MUX to output a low-level signal;
when each group of control bits is 11, the group of control bits controls a corresponding MUX to output a high-level signal; and
when each group of control bits is 01, the group of control bits controls a corresponding MUX to output the smooth signal.

12. The phase-locked loop according to any one of claims 1 to 11, wherein the phase-locked loop further comprises a temperature detector, wherein
the temperature detector is configured to obtain a temperature value of the oscillator; and
the controller is further configured to use, based on the temperature value, a control word corresponding to the temperature value in a preset correspondence as a control word in an initial state, wherein the preset correspondence is a correspondence between a temperature value and a control word.

13. The phase-locked loop according to any one of claims 1 to 12, wherein the phase-locked loop further comprises a control voltage detector, wherein
the control voltage detector is configured to detect the control voltage based on the first preset voltage and the second preset voltage, and indicate, based on a detection result, the controller to determine whether the control voltage changes, wherein the first preset voltage is greater than the second preset voltage.

14. The phase-locked loop according to claim 13, wherein the control voltage detector is configured to:
when detecting that the control voltage is greater than the first preset voltage, output a first status codeword to indicate, to the controller, that the control voltage is greater than the first preset voltage; or when detecting that the control voltage is less than the second preset voltage, output a second status codeword to indicate, to the controller, that the control voltage is less than the second preset voltage.

15. The phase-locked loop according to claim 13 or 14, wherein the control voltage detector comprises a first hysteresis comparator and a second hysteresis comparator, wherein the first preset voltage is input to a first input end of the first hysteresis comparator, and the control voltage is input to a second input end of the first hysteresis comparator; and
the second preset voltage is input to a first input end of the second hysteresis comparator, and the control voltage is input to a second input end of the second hysteresis comparator.
